# EUROPÄISCHE PATENTSCHRIFT

(11) **EP 2 420 734 B1**
(45) Veröffentlichungstag und Bekanntmachung des Hinweises auf die Patenterteilung: **24.07.2019**
(21) Anmeldenummer: 11176502.0
(22) Anmeldetag: 04.08.2011
(51) Int. Cl.: F24C 7/08, A47L 15/42, D06F 39/00, G05B 19/10, H03K 17/97, G05B 19/042

(54) **BEDIENEINRICHTUNG FÜR EIN KOCHFELD**
OPERATING DEVICE FOR A COOKING HOB
DISPOSITIF DE COMMANDE POUR UN FOUR DE CUISSON

(30) Priorität: 20.08.2010 DE 102010039560
(43) Veröffentlichungstag der Anmeldung: 22.02.2012
(73) Patentinhaber: BSH Hausgeräte GmbH, 81739 München (DE)
(72) Erfinder: Has, Uwe, 84579 Unterneukirchen (DE); Schmal, Stefan, 84101 Obersüßbach (DE); Vormann, Ingo, 83413 Fridolfing (DE); Wurnitsch, Ernst, 6382 Kirchdorf in Tirol (AT)

(56) Entgegenhaltungen:
- EP-A2- 1 347 242
- EP-A2- 1 349 281
- EP-A2- 2 251 762
- DE-A1- 3 621 436
- DE-A1- 10 218 294
- DE-A1-102006 026 187
- DE-A1-102006 034 391
- DE-B3- 10 304 985

## Beschreibung

Die Erfindung betrifft eine Bedienvorrichtung für ein Hausgerät, und zwar ein Kochfeld, mit einer Bedienfläche und mit einem Bedienelement, welches auf der Bedienfläche des mit der Bedienvorrichtung steuerbaren Hausgeräts mittels Magnetkraft haltbar ist und relativ zur Bedienfläche bewegbar und von dort abnehmbar positionierbar ist. Das Bedienelement weist eine integrierte und Energie drahtlos übertragende Energieversorgungseinrichtung auf. Des Weiteren betrifft die Erfindung auch ein Hausgerät zum Zubereiten von Lebensmitteln mit einer derartigen Bedienvorrichtung.

Aus der DE 102 18 294 A1 ist eine Vorrichtung zur Steuerung von elektrisch ansteuerbaren Geräten, insbesondere von elektrischen Haushaltsgeräten bekannt. Dafür ist ein mittels Magnetkraft auf einer Kochfläche anbringbarer und relativ dazu drehbarer Bedienknebel ausgebildet, der darüber hinaus auch zur Lichtemission über Lichtleiter ausgebildet ist. Der Bedienknebel ist im Querschnitt U-förmig nach unten orientiert und somit nach unten hin auch offen ausgebildet.

Darüber hinaus ist aus der DE 20 2005 019 978 U1 eine Bedienvorrichtung für ein Elektrogerät bekannt. Diese weist einen von der Kochfläche abnehmbaren Bedienknebel auf, der lediglich relativ zur Kochfläche um eine senkrechte Achse drehbar ist, um entsprechende Betriebseinstellungen vorzunehmen. Die Bedienvorrichtung umfasst darüber hinaus einen Mikroprozessor mit dem es möglich ist, mehrere Schaltmittel abzufragen bzw. verschiedenste Stellungen eines Schaltmittels zu registrieren. Die Energieversorgung des Mikroprozessors ist vorzugsweise über eine induktive Einkopplung von elektrischer Leistung durch Induktionsspulen innerhalb des Bedienelements und unterhalb der Auflagefläche realisiert. Auch hier kann vorgesehen sein, dass der Drehregler in Form des Bedienelements Leuchtmittel in Form von Leuchtdioden aufweist. Die Energieversorgung erfolgt bevorzugt durch kontaktlose Energieübertragung, vorzugsweise induktiv.

Aus der DE 36 21 436 A1 ist eine Bedien- und Anzeigevorrichtung für Hausgeräte bekannt, und an eine Frontplatte der Bedienvorrichtung münden Lichtleiter, wobei die freien Enden der Lichterleiter eben oder als Prisma ausgebildet sein können.

Des Weiteren ist aus der EP 1 349 281 A2 eine Bedienvorrichtung für ein Elektrogerät bekannt. Die Bedienvorrichtung umfasst ein von einer Abdeckung abnehmbares und wieder aufsetzbares Bedienelement.

Des Weiteren ist aus der EP 2 251 762 A2 eine Bedienvorrichtung für ein Elektrogerät bekannt. Bei diesem ist ein Bedienelement im Inneren hohl ausgebildet und umfasst eine Deckscheibe, die transparent ausgebildet ist. Dadurch können optische Anzeigen erfolgen.

Des Weiteren ist aus der DE 10 2006 034 391 A1 eine Bedienvorrichtung für ein Kochfeld bekannt, wobei dazu ein Bedienknebel vorgesehen ist, der relativ zu einer Bedienfläche bewegbar und von dieser auch abnehmbar und wieder darauf positionierbar ist. Im Inneren des Bedienknebels kann eine Lichtquelle vorgesehen sein und das emittierte Licht kann über die Mantelseite des Bedienknebels abgestrahlt werden.

Es ist Aufgabe der vorliegenden Erfindung, eine Bedienvorrichtung für ein Hausgerät mit einem von einer Bedienfläche des Hausgeräts abnehmbaren Bedienelement, welches dort mittels Haltemagnetkraft gehalten ist, im Hinblick auf drahtlose Energieübertragung zu verbessern.

Diese Aufgabe wird durch eine Bedienvorrichtung, welche die Merkmale nach Anspruch 1 aufweist und ein Kochfeld, welches die Merkmale nach Anspruch 8 aufweist, gelöst.

Bei einer erfindungsgemäßen Bedieneinrichtung für ein Kochfeld mit einem Bedienelement, welches auf einer Bedienfläche des mit der Bedienvorrichtung steuerbaren Kochfelds mittels Magnetkraft haltbar ist, und bei welcher das Bedienelement relativ zur Bedienfläche bewegbar von dort abnehmbar positionierbar ist, ist eine Licht abstrahlende Einrichtung an dem Bedienelement vorgesehen. Die das Licht abstrahlende Einrichtung umfasst zumindest ein im Inneren des Bedienelements von außen unsichtbar angeordnete Lichtquelle und das von der Lichtquelle emittierte Licht ist mittels zumindest eines Lichtleiters an eine Lichtaustrittsstelle des Bedienelements leitbar.

Durch eine derartige Ausgestaltung kann die Lichtquelle geschützt angeordnet werden, so dass sie keinem Verschleiß unterliegt. Gerade beim Greifen oder beim Herunterfallen des Bedienelements kann somit eine Beschädigung der Lichtquelle vermieden werden. Darüber hinaus kann durch eine derartige Ausgestaltung eine positionsoptimierte Anbringung der Lichtquelle erzielt werden und Bauraum, welcher für andere Komponenten im Bedienelement benötigt wird, wird nicht eingeschränkt.

Gerade durch die nach außen hin unsichtbare Anordnung der Lichtquelle ist somit erreicht, dass auch nur an gezielten und gewünschten Stellen das Licht austritt und nicht an unerwünschten Stellen Störlicht auftritt.

Erfindungsgemäß ist vorgesehen, dass mittels spezifischer Lichtabstrahlung durch die das Licht abstrahlende Einrichtung des Bedienelements im Hinblick auf Abstrahlrichtung und/oder Lichtfarbe und/oder Betriebsart der Lichtquelle spezifische Betriebseinstellungen des Hausgeräts optisch anzeigbar sind.

Es kann vorgesehen sein, dass die Lichtquelle auf einem Schaltungsträger angeordnet ist, welche in einer Aussparung, insbesondere an einer Oberseite einer Aussparung in einer oberen Abdeckung des Bedienelements angeordnet ist und die Lichtquelle sich in die obere Abdeckung oberhalb der Oberseite erstreckt. Dadurch ist eine sehr geschützte und platzsparende Anordnung der Lichtquelle möglich, die darüber hinaus auch noch mechanisch stabil positionierbar ist.

Insbesondere ist vorgesehen, dass das Bedienelement quasi eine eigene Elektronik aufweist, die weitere Verbraucher in dem Bedienelement, wie Lichtquellen ansteuert. Die entsprechende Energieversorgung ist durch die Energieversorgungseinrichtung gewährleistet.

Vorzugsweise umfasst das Bedienelement auch zumindest ein berührsensitives Bedienfeld, welches beispielsweise ein punktuell zu bedienender Touch-Sensor oder ein berührsensitiver Schieberegler sein kann.

Das Bedienelement umfasst insbesondere eine integrierte und Energie drahtlos übertragende Energieversorgungseinrichtung. In dem Bedienelement ist zumindest eine erste Spule der Energieversorgungseinrichtung angeordnet, welche in ein Ferritmaterial eingebettet ist.

Durch eine derartige Ausgestaltung ist die drahtlose Energieübertragung verbessert. Gerade in relativ kleinen Komponenten, wie es das Bedienelement ist, wird durch eine derartige Ausgestaltung die ausreichende Energieübertragung über eine drahtlose Strecke verbessert. Gerade die relativ schwierige und nur komplex zu bewältigende induktive Energieversorgung kann somit gerade bei derartigen Bedienvorrichtungen verbessert werden.

Insbesondere ist vorgesehen, dass das Bedienelement mit einem innen liegenden Zentralmagneten in Wechselwirkung mit einem unter der Bedienfläche angeordneten weiteren Magneten gehalten ist. Darüber hinaus ist vorzugsweise vorgesehen, dass im Inneren des Bedienelements eine Mehrzahl von Funktionsmagneten angeordnet sind. Mittels dieser kann dann eine gewünschte Betriebsbedingungseinstellung aufgrund von Magnetfeldänderungen erkannt werden. Zur Erkennung sind unter der Bedienfläche eine Mehrzahl von insbesondere Hallsensoren angeordnet, die insbesondere auf einem Schaltungsträger positioniert sind. Wird das Bedienelement gekippt und/oder gedreht, so stellt sich dadurch eine Relativbewegung zu der Bedienfläche und somit auch zu den Hallsensoren dar. Die daraus bewirkte Magnetfeldänderung wird durch diese Sensoren detektiert und damit verbundene Betriebseinstellung erkannt.

Insbesondere ist das Bedienelement ein Dreh-Kipp-Bedienknebel. Dies bedeutet, dass es zur Betriebseinstellung relativ zu einer vertikalen Achse gekippt werden kann und darüber hinaus auch um die Längsachse gedreht werden kann. Befindet sich das Bedienelement in einer ungekippten Grundstellung, so ist die Längsachse gleich der vertikalen Achse. Die Drehung des Bedienelements zur Einstellung von Betriebsbedingungen kann sowohl im Grundzustand als auch im gekippten Zustand erfolgen.

Vorzugsweise sind sechs Funktionsmagnete ausgebildet, die separat und beabstandet zueinander in Umlaufrichtung um die Längsachse äquidistant angeordnet sind.

Insbesondere ist vorgesehen, dass die Bedienvorrichtung für ein Kochfeld ausgebildet ist. Vorzugsweise ist dann vorgesehen, dass durch das Kippen eine Kochzone auswählbar ist und durch Drehen des Bedienelements ein Betriebsparameter dieser ausgewählten Kochzone wertmäßig einstellbar ist.

Vorzugsweise ist das Ferritmaterial auf der der Bedienfläche zugewandten Seite mit einer Nut ausgebildet, in welcher die erste Spule angeordnet ist. Diese versenkte und vom Ferritmaterial umgebene Anordnung der Spule ist im Hinblick auf die induktive Energieübertragung besonders vorteilhaft.

Vorzugsweise weist das Bedienelement eine obere Abdeckung auf, welche, insbesondere vollständig, aus dem Ferritmaterial ausgebildet ist. Dadurch können die oben genannten Vorteile nochmals verbessert werden und darüber hinaus eine besonders kompakte und flachbauende Ausgestaltung des Bedienelements gewährleistet werden.

Es kann auch vorgesehen sein, dass das Bedienelement eine obere Abdeckung aufweist, in welcher ein Ferritteil angeordnet ist. Bei dieser Ausgestaltung ist die obere Abdeckung somit nicht vollständig aus dem Ferritmaterial ausgebildet. Insbesondere ist hier vorgesehen, dass die Abdeckung eine Haube aufweist, in welcher das Ferritteil eingebettet ist. Die Haube ist aus einem zum Ferritmaterial unterschiedlichen Material konzipiert. Beispielsweise kann dies ein Metall, insbesondere Edelstahl, sein. Es kann auch Kunststoff sein.

Durch diese Ausgestaltung ist somit quasi auch das Ferritteil eingebettet in die obere Abdeckung. Eine Beschädigung des Ferritmaterials kann dadurch verhindert werden.

Vorzugsweise ist somit ein kontaktloses Energieübertragungssystem ausgebildet, welches quasi eine transformatorische Magnetanordnung umfasst. Abweichend vom klassischen Transformator ist hier jedoch kein geschlossener Eisenkern ausgebildet. Vielmehr sind die Spulen der Energieversorgungseinrichtung durch einen Luftspalt getrennt. Dieser Luftspalt ist im Wesentlichen mit dem Material der Bedienfläche, insbesondere Glaskeramik beim Kochfeld, und Kunststoff gefüllt. Die Kunststofffüllung ergibt sich dabei insbesondere dadurch, dass das Bedienelement eine untere Abdeckung aufweist, welche aus Kunststoff ausgebildet ist.

Die induktive Energieversorgung mit Ferritkernen ist hier gewährleistet.

Der Ferritkern bzw. das Ferritmaterial im Bedienelement wird durch den Metallmantel der oberen Abdeckung des Bedienelements geformt oder es wird ein Ferritteil gebildet, welches durch die Haube der oberen Abdeckung umgeben ist.

Vorzugsweise ist vorgesehen, dass in der Nut im Ferritmaterial benachbart zur ersten Spule zumindest ein Funktionsmagnet angeordnet. Wie bereits oben erläutert, ist dieser Funktionsmagnet abhängig von der Bewegung des Bedienelements relativ zur Bedienfläche und somit den darunter angeordneten Sensoren zur Betriebsbedingungseinstellung ausgebildet. Durch die Anbringung der ersten Spule und eines Funktionsmagneten in der Nut werden diese unmittelbar nebeneinander positioniert. Dadurch ist eine äußerst kompakte Bauform erzielt.

Vorzugsweise ist eine Mehrzahl von separaten Funktionsmagneten in der Nut beabstandet zueinander angeordnet und sie sind in der erste Spule eingebettet und somit von dieser umwickelt. Durch die außenliegende Positionierung wird eine unerwünschte Beeinflussung und ein nicht zu nahes Positionieren des Funktionsmagneten zu einem zentral positionierten Haltemagneten erreicht.

Vorzugsweise ist vorgesehen, dass ein Funktionsmagnet direkt an der ersten Spule anliegt.

Insbesondere ist in dem Bedienelement ein mittig positionierter Zentralmagnet bzw. Haltemagnet angeordnet, insbesondere nur ein einziger derartiger Haltemagnet vorgesehen. Bevorzugst ist das Ferritmaterial zwischen dem Haltemagnet und der ersten Spule ausgebildet, so dass der Haltemagnet und die Spule durch dieses Ferritmaterial beabstandet und berührungslos zueinander angeordnet sind. Vorzugsweise ist das Bedienelement durch eine untere Abdeckung nach unten verschlossen, welche insbesondere aus Kunststoff ausgebildet ist.

Vorzugsweise ist unter der Bedienfläche eine zweite Spule der Energieversorgungseinrichtung angeordnet, welche ebenfalls in ein Ferritmaterial eingebettet ist. Die Funktionsweise der Energieversorgungseinrichtung kann dadurch besonders effektiv gestaltet werden.

Vorzugsweise ist die zweite Spule und das Ferritmaterial durch einen Luftspalt beabstandet zur Unterseite der Bedienfläche angeordnet. Dadurch können unerwünschte Beschädigungen der Bedienfläche vermieden werden, wenn diese aufgrund von Krafteinwirkungen von oben sich nach unten in Richtung der zweiten Spule und des Ferritmaterials bewegt. Gerade dann, wenn die Bedienfläche aus Glas oder Glaskeramik ausgebildet ist, können dadurch unerwünschte Beschädigungen vermieden werden.

In besonders vorteilhafter Weise ist vorgesehen, dass die Energieversorgungseinrichtung auch zur drahtlosen Übertragung von Datensignalen ausgebildet ist. Neben dem Austausch von Energieversorgungssignalen kann somit eine Multifunktionalität durch die zusätzliche Übertragungsmöglichkeit von Datensignalen gewährleistet werden. Dazu ist somit bei einer Ausgestaltung der Bedienvorrichtung lediglich eine Einrichtung, nämlich die Energieversorgungseinrichtung vorgesehen.

Durch eine derartige Ausgestaltung kann somit einerseits Bauraum und andererseits können dadurch auch Bauteile eingespart werden.

Die Datensignale können bevorzugt als hochfrequent aufmodulierte Signale auf das Wechselfeld der Energieübertragung vorgesehen sein.

Es kann auch vorgesehen sein, dass eine zur Energieversorgungseinrichtung separat ausgebildete Datenübertragungseinrichtung ausgebildet ist, mit welcher Datensignale drahtlos zum Bedienelement hin und/oder von dem Bedienelement weg übertragbar sind. Es kann hier vorgesehen sein, dass die Datenübertragungseinrichtung ebenfalls induktiv arbeitend ausgebildet ist und entsprechende Spulen aufweist.

Ebenso kann vorgesehen sein, dass die Datenübertragungseinrichtung auf Basis von Infrarotsignalen arbeitet. Dazu können Sende-Empfangsdioden vorgesehen sein, die eine Signalübertragung bei 950 nm bis 1000 nm durchführen. Eine in dem Bedienelement angeordnete Sende-Empfangsdiode kann beispielsweise in der Nut der oberen Abdeckung angeordnet sein .

Vorzugsweise weist das Bedienelement eine Leuchteinrichtung mit zumindest einer Lichtquelle auf, welche durch die Energieversorgungseinrichtung mit Energie versorgbar ist.

Bevorzugt ist eine Bedieneinrichtung für ein Hausgerät mit einem Bedienelement ausgebildet, welches auf einer Bedienfläche des mit der Bedienvorrichtung steuerbaren Hausgeräts mittels Magnetkraft haltbar ist und welches relativ zur Bedienfläche bewegbar und von dort abnehmbar positionierbar ist. Das Bedienelement umfasst insbesondere eine lichtabstrahlende Einrichtung.

Insbesondere weist die das Licht abstrahlende Einrichtung eine Projektionsvorrichtung auf, mit welcher abgestrahltes Licht gezielt auf die Bedienfläche des Hausgeräts abstrahlbar ist. Es wird also eine Ausgestaltung geschaffen, bei der nicht nur, wie aus dem Stand der Technik bekannt, von dem Bedienelement Licht unkoordiniert abgestrahlt wird, sondern es soll hier in ganz spezifischer Weise eine Projektion von Licht auf spezifische Stellen der Bedienfläche ermöglicht werden.

Zum einen kann dadurch die Informationsdarstellung für eine Nutzer verbessert werden. Zum anderen können dadurch ganz gezielt Informationen an gewünschten Stellen der Bedienfläche dargestellt werden. Diese Informationen werden somit quasi von dem Bedienelement selbst in ganz gezielter und gerichteter Weise auf die Bedienfläche projiziert.

Vorzugsweise ist die Projektionsvorrichtung zum gezielten Anstrahlen von Symbolen auf der Bedienfläche ausgebildet. Gerade in Wechselwirkung damit kann dem Nutzer situationspezifisch gezielt Information angezeigt werden. Gerade durch das Anstrahlen von Symbolen kann dem Nutzer einfach und intuitiv wahrnehmbar ein Betriebszustand des Hausgeräts und/oder ein durch das Symbol zur vermittelnder sonstiger Informationsgehalt näher gebracht werden.

Das gezielte Abstrahlen des Lichts durch die Projektionsvorrichtung umfasst eine nach unten gerichtete Vorzugsrichtung. Das heißt, gerade dann, wenn das Bedienelement auf der Bedienfläche angeordnet ist und zur Nutzung vorgesehen ist, wird von dem Bedienelement schräg nach unten eine entsprechende Lichtprojektion vorgenommen. Zum einen kann dadurch eine sehr gezielte Lichtbündelung und somit eine sehr lichtstarke optische Anzeige an gezielten Stellen der Bedienfläche erfolgen. Zum anderen können dadurch unerwünschte Blendungen oder störende Lichtabstrahlung nach oben vermieden werden.

Vorzugsweise umfasst die Projektionsvorrichtung einen zur Außenseite des Bedienelements hin freiliegenden Ring als Lichtleiter, mit welchem das Licht gerichtet auf die Bedienfläche projizierbar ist. Durch dieses spezifisch ausgestaltete ringförmige Element an einer ganz spezifischen Stelle des Bedienelements, nämlich an der Umfangsseite, kann die projizierende Vorzugsrichtung nach unten in besonders vorteilhafter Weise realisiert werden. Es kann dadurch eine Lichtprojektion auf die Bedienfläche geschaffen werden, die quasi weiter außen liegt als die Ausmaße des Bedienelements selbst sind. Eine besonders gute Wahrnehmbarkeit der projizierten Informationen kann somit in der Betrachtung von oben des Bedienelements gewährleistet werden, auch dann, wenn das Bedienelement gerade mit einer Hand gegriffen wird und dadurch eine gewisse Abdeckung des Bedienelements durch die Hand von oben erfolgt.

Durch das spezifische Element eines ringförmigen Lichtleiters kann dadurch auch eine sehr vielfältige Projektionsmöglichkeit geschaffen werden. Insbesondere kann in diesem Zusammenhang eine kontinuierliche Linie auf die Bedienfläche projiziert werden. Zusätzlich oder anstatt dazu kann auch vorgesehen sein, dass durch den freiliegenden Ring nur an Ringabschnitten und somit gegebenenfalls auch nur punktweise eine Lichtprojektion auf die Bedienfläche vorgesehen ist. Dieser freiliegende Ring ist somit ein ganz spezifisches Element in Form und Ausgestaltung, welches in variabler und flexibler Weise eine vielfältige Lichtprojektion auf die Bedienfläche ermöglicht.

Insbesondere ist vorgesehen, dass in dem Bedienelement zumindest eine Lichtquelle, insbesondere eine Leuchtdiode angeordnet ist. Derartige Licht emittierende Bauteile sind besonders klein und energieeffizient betreibbar. Darüber hinaus ermöglichen sie eine hohe Leuchtdichte und gewähren darüber hinaus auch die Möglichkeit unterschiedliche Lichtfarben abzustrahlen.

Vorzugsweise ist vorgesehen, dass das von der zumindest einen Lichtquelle emittierte Licht zur Seite und/oder nach oben und nach unten von dem Bedienelement gerichtet abstrahlbar ist.

Insbesondere ist vorgesehen, dass zumindest eine Lichtquelle im Inneren des Bedienelements angeordnet ist, und zwar derart, dass sie von außen unsichtbar positioniert ist. Durch diese ganz spezifische innenliegende Anordnung kann die Lichtquelle vor Beschädigung geschützt werden. Die unsichtbare Anordnung gewährleistet darüber hinaus auch, dass kein unerwünschter Lichtaustritt erfolgt, sondern dass das von der Lichtquelle emittierte Licht ganz gezielt im Inneren des Bedienelements an gewünschte Lichtaustrittsstellen geleitet werden kann und dadurch nur an diesen Stellen Lichtaustritt erfolgt.

Darüber hinaus kann durch diese Ausgestaltung auch erreicht werden, dass es im Inneren quasi unabhängig ist, wo die Lichtquelle positioniert wird, so dass die geeignetste Position im Hinblick auf Bauraum und Unterbringung von anderen Komponenten in dem Bedienelement gewählt werden kann, ohne dass dies nachteilig wäre im Hinblick auf unerwünschten Lichtaustritt und andererseits gezielten Lichtaustritt an gewünschten Stellen.

Vorzugsweise ist vorgesehen, dass bei einer derartigen Anordnung das von der Lichtquelle emittierte Licht mittels zumindest einem Lichtleiter an eine gezielte Lichtaustrittsstelle des Bedienelements leitbar ist.

Der Lichtleiter kann in diesem Zusammenhang ebenfalls vollständig integriert in dem Bedienelement angeordnet sein. Er kann an eine punktuelle Lichtaustrittsstelle münden oder in einen weiteren größeren Lichtleiter, beispielsweise den bereits oben angesprochenen ringförmigen nach außen hin freiliegenden Lichtleiter münden.

Es ist vorgesehen, dass an einer Lichtaustrittsstelle des Bedienelements eine gezielte Lichtabstrahlung in eine projizierende Vorzugsrichtung ein optisches Element angeordnet ist. Hier ist vorgesehen, dass an einer Lichtaustrittsstelle ein Prisma angeordnet ist. Durch dieses ganz spezifische Bauteil und deren individuelle Anordnung können ganz gezielt Vorzugsrichtungen im Hinblick auf die Lichtprojektion eingestellt werden. Es können durch dieses Bauteil sogar mehrere Vorzugsrichtungen gleichzeitig vorgegeben werden. So kann in diesem Zusammenhang das Prisma an einer Lichtaustrittsseite an der Mantelwand bzw. Umfangswand des Bedienelements angeordnet sein und zwar derart, dass eine erste Vorzugsrichtung schräg nach unten auf die Bedienfläche gerichtet ist und eine zweite Vorzugsrichtung vertikal nach oben gerichtet ist. Zusätzlich oder anstatt dazu kann eine weitere Vorzugsrichtung dahingehend vorgesehen sein, dass quasi auch eine horizontale Lichtabstrahlung gewährleistet ist.

Insbesondere ist zu erwähnen, dass auch bei mehreren Vorzugsrichtungen keine Lichtabstrahlung über einen großen Winkelbereich und über diesen gleichmäßig erfolgt, sondern dass auch hier nur ganz spezifisch in dieser konkreten Richtung die Lichtabstrahlung und Projektion erfolgt, und somit in fokussierter Lichtabstrahlbündelung erfolgt.

Vorzugsweise ist vorgesehen, dass das Bedienelement eine obere und eine untere Abdeckung aufweist, die beide miteinander verbunden sind und ein geschlossenes Bedienelement bilden. Insbesondere ist die Projektionsvorrichtung in der oberen Abdeckung integriert. Dies ist einerseits besonders vorteilhaft im Hinblick auf die möglichen Lichtprojektionen und somit die Position und der Abstand relativ zur Bedienfläche. Andererseits wird dadurch in einem zwischen der oberen Abdeckung und der unteren Abdeckung gebildeten Hohlraum der dadurch erzeugte Bauraum für weitere Komponenten, insbesondere Funktionsmagnete, Haltemagnet, Spulen einer Energieversorgungseinrichtung und dergleichen nicht geschmälert.

Vorzugsweise weist diese Licht abstrahlende Einrichtung eine Mehrzahl an dem Bedienelement angeordneten Lichtquellen auf, die mittels einer Steuereinheit einzeln ansteuerbar sind.

Durch eine derartige Möglichkeit können unterschiedliche optische Anzeige und Projektionen nacheinander oder gleichzeitig erfolgen, wodurch die Anzeigevielfalt wesentlich erhöht wird. Nicht zuletzt kann dadurch auch die Signalisierung präzisiert und für den Nutzer leichter wahrnehmbar ermöglicht werden.

Es können in diesem Zusammenhang Lichtquellen vorgesehen sein, die auch zur Emittierung von Lichtstrahlen unterschiedlicher Lichtfarbe ausgebildet sind. Ebenso kann die Steuerung dahingehend erfolgen, dass eine Lichtquelle blinkend betreibbar ist oder auch kontinuierlich aktiviert ist.

Sind mehrere Lichtquellen oder Lichtaustrittsbereiche des Bedienelements in einer Reihenfolge oder im Kreis oder dergleichen angeordnet, so können diese auch entsprechend nacheinander angesteuert werden, so das quasi auch ein Lauflicht erzeugt werden kann. Insbesondere kann durch die Beleuchtung eine Information für den Nutzer über spezifische Betriebszustände des Hausgeräts vermittelt werden. Informationen können dabei beispielsweise den eingeschalteten und ausgeschalteten Zustand umfassen, einen Stand-by-Zustand umfassen etc..

Es kann auch vorgesehen sein, dass die das Licht abstrahlende Einrichtung eine Mehrzahl von in dem Bedienelement angeordnete Lichtquellen aufweist, die symmetrisch um eine Längsachse des Bedienelements angeordnet sind und zur Lichtabstrahlung über die Oberseite des Bedienelements ausgebildet sind. Auch dadurch können ganz spezifische und für einen Nutzer bei einer Betrachtung von oben leicht erkennbare Informationen optisch angezeigt werden.

Durch die Mehrzahl und die rotationssymmetrische Anordnung können auch hier variable optische Lichtbilder erzeugt werden. Insbesondere kann durch eine Lauflichtdarstellung im Uhrzeigersinn oder gegen den Uhrzeigersinn auch eine entsprechende Betätigungsrichtung im Hinblick auf Betriebsbedingungseinstellungen für das Bedienelement angezeigt werden.

Vorzugsweise ist vorgesehen, dass zumindest eine Lichtquelle der das Licht abstrahlenden Einrichtung hinter einem Anzeigeelement oder einem Design-Element des Bedienelements in dem Bedienelement angeordnet ist. Durch das Licht der Lichtquelle ist dann das Anzeigeelement für einen Betrachter kenntlich hinterleuchtbar oder das Design-Element hinterleuchtbar. Auch dadurch können ganz spezifische Ausgestaltungen im Hinblick auf Informationsanzeige generiert werden. So kann hier vorgesehen sein, dass bei deaktivierter Lichtquelle auch das Anzeigeelement nicht erkennbar ist und erst mit Aktivierung der Lichtquelle das Anzeigeelement für einen Nutzer erkennbar ist. Dadurch kann ein aufgeräumter für einen Nutzer nicht überfrachteter Anzeigebereich des Bedienelements generiert werden. Im Hinblick auf die Hinterleuchtung eines Design-Elements kann in diesem Zusammenhang hohen Qualitätsansprüchen Rechnung getragen werden.

Vorzugsweise weist das Bedienelement eine integrierte Energieversorgungseinrichtung für die das Licht abstrahlende Einrichtung auf.

Die Bedienvorrichtung umfasst insbesondere ein Gesamtsystem aus einer Basiselektronik außerhalb des Bedienelements, vorzugsweise unter der Bedienfläche, und der Elektronik in dem Bedienelement. Die Basiselektronik treibt vorzugsweise die Primärseite eines induktiven Übertragers.
In einer Bauform der Bedienvorrichtung erfolgt nur eine Energieübertragung von der Basiselektronik im Bedienelement. Wird die Energieübertragung aktiviert, leuchten die Lichtquellen im Bedienelement. Durch das Ein- und Ausschalten der Energieübertragung kann auch ein Blinken der Lichtquellen erzeugt werden.

In einer weiteren Bauform erfolgt zusätzlich zur Energieübertragung eine unidirektionale Datenübertragung von der Primärseite zur Sekundärseite.

In einer weiteren Bauform erfolgt zusätzlich zur Energieübertragung einr unidirektionale Datenübertragung von der Sekundärseite zur Primärseite hin, so dass quasi auch eine bidirektionale Datenübertragung realisiert ist. Dadurch kann zum Beispiel ein Datensignal gesendet werden, wenn der Benutzer das Bedienelement mit der Hand oder dem Finger berührt. Mehrere Tasten sind ebenfalls möglich. So kann zum Beispiel eine spezielle Touch-Bedienung eines Sensors getrennt von der schlichten Berührung des Bedienelements oder einer gewohnten Bewegung des Bedienelements erfasst werden, um so durch redundante Informationen die Betriebssicherheit des Systems zu erhöhen. Auch entsprechende Kombinationen der Bauformen sind selbstverständlich möglich.

Insbesondere ist das Bedienelement mit seiner oberen Abdeckung aus Edelstahl ausgebildet.

Im Hinblick auf das oben angesprochene Design-Element, welches durch eine Lichtquelle beleuchtbar oder hinterleuchtbar ist, kann beispielsweise ein Edelstein oder ein sonstiges lichttransparentes Bauteil vorgesehen sein.

Als Lichtquelle kann auch eine Laserdiode vorgesehen sein.

Im Hinblick auf die bereits oben angesprochene Elektronik ist insbesondere vorgesehen, dass die Basiselektronik die Primärspule, welche die zweite Spule unter der Bedienfläche ist, betreibt.

In der Sekundärspule, welche die erste Spule im Bedienelement ist, induziert das Wechselfeld eine Spannung, welche dann gleichgerichtet und geglättet wird und so zur Energieversorgung für die Leuchtdioden verwendbar ist.

Es kann auch eine Elektronik mit Spannung versorgt werden, die zur Steuerung weiterer Funktionen dient.

Vorzugsweise ist vorgesehen, dass an der Oberseite des Bedienelements ein berührsensitives Bedienfeld, insbesondere mittig, ausgebildet ist. Vorzugsweise sind um dieses Bedienfeld herum eine Mehrzahl von Lichtaustrittsabschnitten oder Lichtquellen angeordnet, so dass Licht nach oben von dem Bedienelement abstrahlbar ist.

Es kann auch vorgesehen sein, dass auch das übrige dann aus Metall ausgebildete Gehäuse des Bedienelements insbesondere die obere Abdeckung, als Sensor ausgebildet ist.

Weitere Merkmale der Erfindung ergeben sich aus den Ansprüchen, den Figuren und der Figurenbeschreibung.

Ausführungsbeispiele der Erfindung werden nachfolgend anhand schematischer Zeichnungen näher erläutert. Es zeigen:
- Fig. 1: eine perspektivische Darstellung eines Ausführungsbeispiels eines erfindungsgemäßen Kochfelds mit einem Ausführungsbeispiel einer erfindungsgemäßen Bedieneinrichtung;
- Fig. 2: eine schematische Schnittdarstellung durch ein erstes Ausführungsbeispiel einer erfindungsgemäßen Bedienvorrichtung;
- Fig. 3: eine schematische Schnittdarstellung durch ein zweites Ausführungsbeispiel einer erfindungsgemäßen Bedienvorrichtung;
- Fig. 4: eine Draufsicht auf eine Ausführungsform eines Bedienelements einer erfindungsgemäßen Bedienvorrichtung;
- Fig. 5: eine Schnittdarstellung des Bedienelements gemäß Fig. 4;
- Fig. 6: eine Draufsicht auf einen Teilausschnitt eines Kochfelds mit einem Ausführungsbeispiel einer erfindungsgemäßen Bedienvorrichtung; und
- Fig. 7: eine Schnittdarstellung durch das Bedienelement in Fig. 6.

In den Figuren werden gleiche oder funktionsgleiche Elemente mit den gleichen Bezugszeichen versehen.

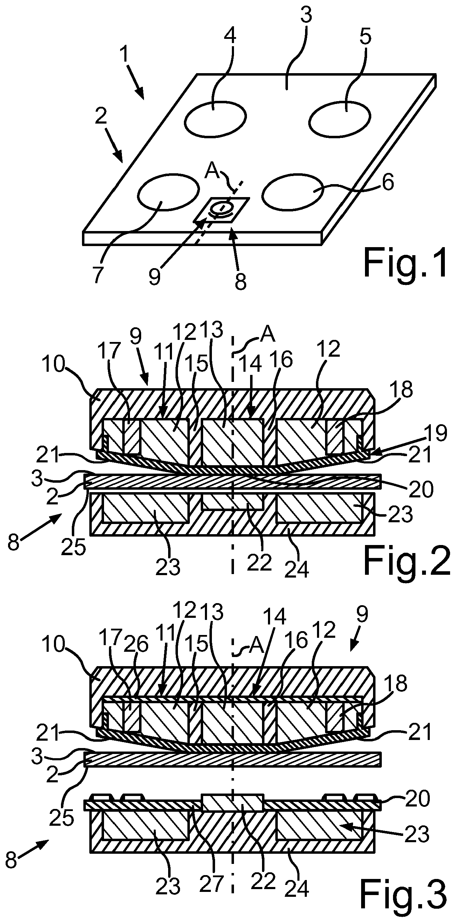

In Fig. 1 ist in einer perspektivischen schematischen Darstellung ein Kochfeld 1 gezeigt, welches ein Hausgerät zum Zubereiten von Lebensmitteln darstellt. Das Kochfeld 1 umfasst eine Kochfeldplatte 2, welche beispielsweise aus Glas oder Glaskeramik ausgebildet ist. Die Kochfeldplatte 2 umfasst eine Oberseite, welche als Kochfläche bzw. Bedienfläche 3 ausgebildet ist. Auf dieser Bedienfläche 3 sind im Ausführungsbeispiel vier Kochzonen 4, 5, 6 und 7 vorgesehen. Auf diesen können Zubereitungsgefäße wie Töpfe und Pfannen oder dergleichen aufgestellt werden und die Kochzonen 4 bis 7 durch entsprechende Heizeinrichtungen, beispielsweise Strahlungsheizkörper oder Induktoren beheizt werden.

Darüber hinaus umfasst das Kochfeld 1 eine Bedienvorrichtung 8. Die Bedienvorrichtung 8 umfasst darüber hinaus ein einziges Bedienelement 9, welches als Dreh-Kipp-Bedienknebel ausgebildet ist. Das diskusförmige Bedienelement 9 ist um seine Längsachse A drehbar. Das Bedienelement 9 ist mittels Magnetkraft auf der Bedienfläche 3 haltbar und relativ gegenüber der Bedienfläche 3 drehbar und kippbar. So kann vorgesehen sein, dass mit einem Kippen um einen Winkel zur Vertikalachse eine der Kochzonen 4 bis 7 auswählbar ist und durch ein Drehen um die Achse A eine Einstellung eines Betriebsparameters dieser ausgewählten Kochzonen 4 bis 7 ermöglicht ist.

Das Bedienelement 9 kann darüber hinaus auch zerstörungsfrei reversibel von der Bedienfläche 2 abgenommen werden, indem durch Überwindung der magnetischen Haltekraft das Bedienelement 9 gelöst wird.

Zur weiteren Erläuterung werden Ausführungsbeispiele der Bedienvorrichtung 8 beschrieben.

In Fig. 2 ist dazu eine Schnittdarstellung durch ein erstes Ausführungsbeispiel gezeigt. Das Bedienelement 9 umfasst eine obere Abdeckung 10, welche im gezeigten Ausführungsbeispiel einstückig ausgebildet ist und darüber hinaus vollständig aus einem Ferritmaterial ausgebildet ist. Die obere Abdeckung kann noch durch eine Kunststoffhülle umgeben sein. Die Bedienvorrichtung 8 umfasst eine drahtlos arbeitende Energieversorgungseinrichtung, welche zur induktiven Energieübertragung ausgebildet ist. Teilkomponenten der Energieübertragungsvorrichtung sind dazu in dem Bedienelement 9 angeordnet. Das Bedienelement 9 weist somit auch eine integrierte drahtlos arbeitende Energieversorgungseinrichtung auf. Dazu ist vorgesehen, dass auf der der Kochfeldplatte 2 zugewandten Seite eine Vertiefung in Form einer Nut 11 ausgebildet ist. In dieser Nut 11 ist eine der Energieversorgungseinrichtung zugehörige erste Spule 12 angeordnet. Die Spule 12, welche die Sekundärspule einer transformatorischen Anordnung darstellt, ist somit von oben und von der Seite durch das Ferritmaterial der oberen Abdeckung 10 umgeben. Zentral mittig in dem Bedienelement 9 ist ein Haltemagnet 13 positioniert. Dieser ist in einer Vertiefung 14 in der oberen Abdeckung 10 passgenau angeordnet. Durch Stege 15 und 16 der oberen Abdeckung 10 ist der Haltemagnet 13 von der ersten Spule 12 beabstandet und berührungslos angeordnet.

In der Nut 11 ist neben der Spule 12 ein Funktionsmagnet 17 und ein weiterer Funktionsmagnet 18 angeordnet. Die Funktionsmagneten 17 und 18 sind in der ersten Spule 12 eingebettet und somit von dieser umwickelt.

Insgesamt umfasst das Bedienelement 9 im Ausführungsbeispiel sechs derartiger Funktionsmagnete 17 bzw. 18, die in Umlaufrichtung um die Achse A äqudistant zueinander angeordnet sind.

Wie zu erkennen ist, ist die Spule 12 quasi eingebettet in das Ferritmaterial angeordnet. Nach unten hin ist das Bedienelement 9 durch eine untere Abdeckung 19 verschlossen. Die beiden Abdeckungen 10 und 19 können lösbar miteinander verbunden sein, beispielsweise durch eine Rastverbindung oder eine Schnappverbindung. Durch die beiden Abdeckungen 10 und 19 wird ein vollständig geschlossenes Bedienelement 9 ausgebildet.

Die untere Abdeckung 19 ist vorzugsweise aus Kunststoff. Wie zu erkennen ist, ist die Außenseite der unteren Abdeckung 19 uneben ausgebildet. Zentral mittig ist eine ebene Fläche 20 ausgebildet und in der Darstellung in Fig. 2 ist das Bedienelement 9 in seiner Grundstellung gezeigt. Dies bedeutet, dass es im ungekippten Zustand dargestellt ist. Angrenzend an diesen ebenen mittigen Flächenabschnitt 20 ist dann ein schräg nach oben gerichteter Flächenabschnitt 21 umlaufend um die Achse A ausgebildet. Dadurch kann die Kippbewegung realisiert werden.

Unter der Kochfeldplatte 2 sind weitere Komponenten der Energieversorgungseinrichtung angeordnet. Es ist hier ebenfalls ein weiterer Haltemagnet 22 vorgesehen. Dieser ist ebenso wie eine zweite Spule 23, welche die Primärspule des induktiven Energieübertragungssystems darstellt, in einem Ferritmaterial 24 eingebettet. Es ist zu erkennen, dass das Ferritmaterial 24, die zweite Spule 23 und der Haltemagnet 22 durch einen Luftspalt beabstandet zu einer Unterseite 25 der Kochfeldplatte 2 angeordnet sind.

Auch die zweite Spule 23 ist in das Ferritmaterial quasi passgenau eingebettet.

Die Bedienvorrichtung 8 umfasst darüber hinaus eine nicht dargestellte Elektronik, die zur Erfassung der Bewegung und der Positionszustände des Bedienelements 9 ausgebildet ist. Insbesondere sind dabei Hallsensoren vorgesehen, die die Drehstellung und Kippstellung des Bedienelements 9 anhand Magnetfeldänderungen der Funktionsmagnete 17 und 18 detektieren.

Die Basiselektronik ist darüber hinaus auch zur Ansteuerung der zweiten Spule 23, welche die Primärspule darstellt ausgebildet, über welche dann ein Wechselfeld erzeugt wird und eine Energieübertragung auf die erste Spule 12 erfolgt.

In dem Bedienelement 9 ist vorzugsweise ebenfalls eine in Fig. 2 nicht dargestellte Elektronik vorhanden. Diese kann dann in Verbindung mit der integrierten Energieübertragungseinrichtung eine Energieversorgung und einen Betrieb von weiteren Komponenten, beispielsweise einer Licht abstrahlenden Einrichtung und der Lichtquellen ermöglichen. Darüber hinaus kann auch die Detektion von an dem Bedienelement 9 ausgebildeten berührsensitiven Bedienfeldern und deren Betätigung erfasst werden. Darüber hinaus kann das Bedienelement 9 auch eine Projektionsvorrichtung zur optischen Lichtprojektion beispielsweise auf die Bedienfläche 3 aufweisen. Entsprechende Ausgestaltungen werden im weiteren noch erläutert.

In Fig. 3 ist ein weiteres Ausführungsbeispiel einer Bedienvorrichtung 8 gezeigt. Hier ist im Unterschied zur Ausgestaltung in Fig. 2 in der oberen Abdeckung 10 ein erster Schaltungsträger 26 integriert. Dieser kann die bereits oben angesprochene Elektronik aufweisen und darüber hinaus auch gegebenenfalls Lichtquellen oder dergleichen aufweisen.

Entsprechend ist in der Darstellung gemäß Fig. 3 ein Schaltungsträger 27 gezeigt. Dieser kann vorzugsweise die oben bereits angesprochene Basiselektronik aufweisen.

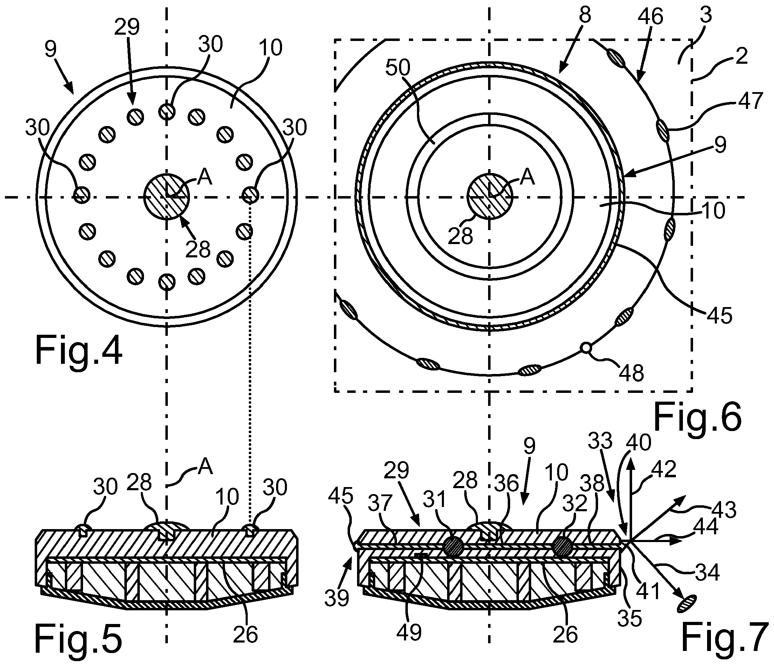

In Fig. 4 ist ein weiteres Ausführungsbeispiel eines Bedienelements 9 einer Bedienvorrichtung 8 gezeigt. Die scheibenförmige Ausgestaltung bei der Draufsichtdarstellung ist zu erkennen. In dieser Ausgestaltung ist vorgesehen, dass in der oberen Abdeckung 10 mittig zentriert ein berührsensitives Bedienfeld 28 vorgesehen ist. Dies kann beispielsweise zum Ein- und Ausschalten der Bedienvorrichtung 8 und somit des Kochfelds 1 vorgesehen sein. Es könne jedoch auch andere Funktionalitäten damit verbunden sein, beispielsweise das Aktivieren oder Deaktivieren einer Licht von dem Bedienelement 9 abstrahlenden Einrichtung 29. Diese umfasst im Ausführungsbeispiel eine Mehrzahl von Lichtquellen 30 (es wird lediglich eine der Lichtquellen mit einem Bezugszeichen versehen, die Weiteren sind in der Darstellung gemäß Fig. 4 in Anzahl und Position eindeutig erkennbar). Die Lichtquellen 30 sind im Ausführungsbeispiel Leuchtdioden, welche in Umlaufrichtung um die Achse A äquidistant zueinander angeordnet sind.

Wie in der schematischen Schnittdarstellung in Fig. 5 dazu zu erkennen ist, sind sowohl das berührsensitive Bedienelement 28 als auch die Lichtquellen 30 in die obere Abdeckung 10 integriert.

Der Übersichtlichkeit dienend sind in der Darstellung gemäß Fig. 5 die in den Fig. 2 und 3 genannten Magnete und Spulen nicht eingezeichnet. Prinzipiell können auch diese Komponenten betreffend die Magnete, Spulen und weiteren Komponenten im Hinblick auf die Elektronik auch in der Ausgestaltung gemäß Fig. 4 und Fig. 5 des Bedienelements 9 vorhanden sein.

Im Hinblick auf die Ausgestaltung der oberen Abdeckung 10 vollständig aus Ferritmaterial, kann auch vorgesehen sein, dass lediglich ein Ferritteil vorgesehen ist, in dem dann die Spule 12 und die Funktionsmagneten 17 und 18 in einer entsprechenden Nut 11 positioniert sind. Auch kann dann der Haltemagnet 13 in einer entsprechenden Aussparung 14 angeordnet sein. Dieses Ferritteil ist dann von oben und von der Seite durch eine Haube oder eine Abdeckung 10 abgedeckt, wobei die Haube aus einen zum Ferrit unterschiedlichen Material ausgebildet ist, beispielsweise aus Edelstahl ist.

Im Hinblick auf die Ausgestaltung der Bedienvorrichtung 8 kann vorzugsweise vorgesehen sein, dass die Energieversorgungseinrichtung auch zur Datenübertragung ausgebildet ist. Insbesondere ist dabei möglich, dass diese Datenübertragung der Datensignale drahtlos erfolgt. In einer vorteilhaften Ausführung ist vorgesehen, dass ein Datensignal ein auf das Wechselfeld der Energieübertragung hochfrequent aufmoduliertes Signal ist.

Es kann jedoch auch vorgesehen sein, dass separat zu einer Energieversorgungseinrichtung eine Datenübertragungseinrichtung ausgebildet ist, mit welcher Datensignale drahtlos zum Bedienelement 9 und/oder von dem Bedienelement 9 zur Basiselektronik übertragbar sind. Auch hier kann diese Datenübertragungseinrichtung induktiv arbeitend ausgebildet sein oder auf der Basis von IR (Infrarot) - Signalen arbeiten. Dazu kann dann eine IR-Sende-Empfangsdiode in der Nut 11 angeordnet sein, die mit einer insbesondere unter der Kochfeldplatte angeordneten weitere IR-Sende-Empfangsdiode Signale austauscht.

In Fig. 6 ist ein weiteres Ausführungsbeispiel einer Bedienvorrichtung 8 gezeigt, wobei die Draufsicht auf ein auf der Kochfeldplatte 2 positioniertes Bedienelement 9 zu sehen ist. Bei dieser Ausgestaltung umfasst das Bedienelement 9 zumindest eine, vorzugsweise mehrere im Inneren des Bedienelements 9 angeordnete Lichtquellen 31 und 32. Diese sind darüber hinaus so positioniert, dass sie von außen unsichtbar angeordnet sind. Wie in der Schnittdarstellung gemäß Fig. 7 dazu zu erkennen ist, ist auch hier wiederum eine integrierte Einbettung in die obere Abdeckung 10 ausgebildet.

Die Lichtquellen 31 und 32 sind Leuchtdioden. Sie sind einer Licht abstrahlenden Einrichtung 29 zugeordnet. Diese Licht abstrahlende Einrichtung 29 umfasst darüber hinaus auch eine Projektionsvorrichtung 33. Im Ausführungsbeispiel ist dazu vorgesehen, dass diese Projektionsvorrichtung 33 von den Bedienelementen 9 nach außen abgestrahltes Licht als Lichtbündel in eine gezielte Vorzugsrichtung emittieren kann.

Erfindungsgemäß ist vorgesehen, dass das Licht gemäß einer ersten Vorzugsrichtung 34 von einer Mantelseite 35 des Bedienelements 9 schräg gerichtet nach unten auf die Bedienfläche 3 abgestrahlt wird.

Im Ausführungsbeispiel umfasst die das Licht abstrahlende Einrichtung 29 in der oberen Abdeckung 10 integrierte Lichtleiter 36, 37 und 38. Diese weisen Lichtaustrittstellen 39 und 40 auf, aus denen das Licht aus dem Bedienelement 9 austritt. Im Ausführungsbeispiel ist vorgesehen, dass an der Lichtaustrittstelle 40 ein optisches Element angeordnet ist, welches die gezielte Lichtabstrahlung in eine projizierende Vorzugsrichtung gewährleistet. Im Ausführungsbeispiel ist dieses optische Element ein Prisma 41. Dies gewährleistet zum einen die Abstrahlung in die Vorzugsrichtung 34 als auch die Abstrahlung eines Lichtbündels in eine weitere Vorzugsrichtung 42 senkrecht nach unten. Es können zusätzlich oder anstatt dazu auch Ausgestaltungen vorgesehen sein, bei denen eine Vorzugsrichtung 43 schräg nach oben und/oder eine weitere Vorzugsrichtung 44 horizontal nach außen vorgesehen ist und entsprechende Lichtbündel dorthin abgestrahlt werden.

In einer weiteren Ausführung kann auch vorgesehen sein, dass die das Licht abstrahlende Einrichtung 29 eine Projektionsvorrichtung 33 mit einem nach außen und insbesondere zur Umfangsseite bzw. Mantelseite 35 hin freiliegenden ringförmigen Lichtleiter 45 aufweist. Dieser ist vorzugsweise vollständig umlaufend ausgebildet.

Es können in diesem Zusammenhang Ausgestaltungen des Bedienelements 9 vorgesehen sein, die sowohl diesen ringförmigen Lichtleiter 45 als auch ein oder mehrere derartige Prismen 41 aufweisen. Es können jedoch auch nicht erfindungsgemäße Ausgestaltungen vorgesehen sein, die nur diesen ringförmigen Lichtleiter 45 und keine derartigen Prismen 41 aufweist.

Ebenso sind Ausgestaltungen möglich, die keinen derartigen ringförmigen Lichtleiter 45 und ein oder mehrere derartige Prismen 41 an den Austrittsstellen 39 bzw. 40 aufweisen.

In der Darstellung gemäß Fig. 6 ist der ringförmige umlaufende Lichtleiter 45 zu erkennen. Es kann nur in Verbindung mit der Projektionsvorrichtung 33 mit der Vorzugsrichtung 34 somit eine schräg nach außen gerichtete Lichtprojektion gezielt auf die Oberseite bzw. Bedienfläche 3 ermöglicht werden. Es kann dadurch ein vollständig kontinuierlich umlaufender Lichtring 46 auf der Bedienfläche 3 erzeugt werden. Zusätzlich oder anstatt dazu können auch ganz gezielt größere Lichtflecken 47 generiert werden.

Dadurch können ganz spezifische Betriebszustände oder Informationen auf die Oberfläche bzw. die Bedienfläche 3 projiziert werden.

Insbesondere kann abhängig von der Ausgestaltung der Kochfeldplatte 2 und der verwendeten Lichtstrahlung eine Konstellation geschaffen werden, bei der auch nur ganz spezifische auf der Bedienfläche 3 ausgebildete Symbole 48 angestrahlt und beleuchtet werden. Die Position, Formgebung und Anzahl derartiger Symbole 48 ist in Fig. 6 lediglich beispielhaft. Durch Drehen und/oder Kippen des Bedienelements 9 können die Lichtprojektionen in vielfältiger Weise geändert und variiert werden und die angestrahlte Stelle auf der Bedienfläche 3 geändert werden.

Die insbesondere auf dem Schaltungsträger 26 ausgebildete Elektronik kann auch eine Steuereinheit 49 umfassen, mittels welcher die Lichtquellen 31 und 32 gezielt im Betrieb ansteuerbar sind. Dabei kann eine alternierende Ansteuerung, ein Blinken oder dergleichen ermöglicht werden. Der Schaltungsträger 26 liegt an einer Oberseite einer Aussparung der oberen Abdeckung 10 an. Die Lichtquellen 31 und 32 erstrecken sich vom Schaltungsträger 26 durch die Oberseite in das Material der oberen Abdeckung 10 hinein.

Es kann auch vorgesehen sein, dass das Bedienelement 9, insbesondere in der Abdeckung 10, ein Anzeigeelement und/oder ein Design-Element aufweist, welches durch Lichtquellen in dem Bedienelement 9 hinterleuchtbar ist.

Ein Design-Element kann beispielsweise ein umlaufender Ring 50 sein. Ein Anzeigeelement kann beispielsweise auch ein berührsensitives Bedienelement 28 sein. Im aktiven Zustand kann es dann hinterleuchtet werden, so dass es für den Nutzer jederzeit erkennbar ist. Ist die Lichtquelle zum Hinterleuchten dieses Anzeigeelements deaktiviert, so kann vorzugsweise vorgesehen sein, dass die gestalterische und farbliche Abstimmung des Bedienfelds 28 an die weitere Umgebung und Ausgestaltung der oberen Abdeckung 10 angepasst ist. Ist die Lichtquelle zum Hinterleuchten des Bedienfelds 28 deaktiviert, so kann somit quasi das Bedienelement 28 nicht mehr ohne Weiteres erkannt werden.

Auch die Ausgestaltung gemäß Fig. 6 und Fig. 7 kann zusätzlich auch eine Energieversorgungseinrichtung aufweisen, wie sie in den Ausgestaltungen gemäß Fig. 2 oder 3 dargestellt ist.

### Bezugszeichenliste

- 1: Kochfeld
- 2: Kochfeldplatte
- 3: Bedienfläche
- 4, 5, 6, 7: Kochzonen
- 8: Bedienvorrichtung
- 9: Bedienelement
- 10: Abdeckung
- 11: Nut
- 12: Spule
- 13: Haltemagnet
- 14: Vertiefung
- 15, 16: Stege
- 17, 18: Funktionsmagnete
- 19: Abdeckung
- 20, 21: Flächen
- 22: Haltemagnet
- 23: Spule
- 24: Ferritmaterial
- 25: Unterseite
- 26, 27: Schaltungsträger
- 28: Bedienfeld
- 29: Einrichtung
- 30, 31, 32: Lichtquellen
- 33: Projektionsvorrichtung
- 34: Vorzugsrichtung
- 35: Mantelseite
- 36, 37, 38: Lichtleiter
- 39, 40: Lichtaustrittstellen
- 41: Prisma
- 42, 43, 44: Vorzugsrichtungen
- 45: Lichtleiter
- 46: Lichtring
- 47: Lichtflecken
- 48: Symbole
- 49: Steuereinheit
- 50: Ring

## Patentansprüche

1. Bedienvorrichtung für ein Kochfeld (1), mit einer Bedienfläche (3) und mit einem Bedienelement (9), welches auf der Bedienfläche (3) des mit der Bedienvorrichtung (8) steuerbaren Kochfelds (1) mittels Magnetkraft haltbar ist und relativ zur Bedienfläche (3) bewegbar und von dort abnehmbar positionierbar ist, und das Bedienelement (9) eine Licht abstrahlende Einrichtung (29) aufweist, wobei die das Licht abstrahlende Einrichtung (29) zumindest eine im Inneren des Bedienelements (9) angeordnete Lichtquelle (31, 32) aufweist und das von der Lichtquelle (31, 32) emittierte Licht mittels zumindest eines Lichtleiters (36 bis 38) an eine Lichtaustrittsstelle (39, 40) des Bedienelements (9) leitbar ist, **dadurch gekennzeichnet, dass** das von der Lichtquelle (31, 32) emittierte Licht nach unten gerichtet von dem Bedienelement (9) abstrahlbar ist, und an einer Lichtaustrittsstelle (39, 40) des Bedienelements (9) ein die gezielte Lichtabstrahlung in eine projizierende Vorzugsrichtung (34, 42 bis 44) gewährleistendes optisches Element angeordnet ist und das gezielte Lichtabstrahlen eine schräg nach unten gerichtete Vorzugsrichtung (34) umfasst, wenn das Bedienelement (9) auf der Bedienfläche (3) angeordnet ist, zu welchem Zweck an einer umfangsseitlichen Lichtaustrittstelle des Bedienelements (9) ein die gezielte Lichtabstrahlung in eine projizierende Vorzugsrichtung (34, 42 bis 44) gewährleistendes Prisma (41) angeordnet ist.

2. Bedienvorrichtung nach Anspruch 1, **dadurch gekennzeichnet, dass** die Lichtquelle (31, 32) eine Leuchtdiode ist.

3. Bedienvorrichtung nach Anspruch 1 oder 2, **dadurch gekennzeichnet, dass** die Lichtquelle (31, 32) in das Bedienelement (9) integriert ist und von dem Material des Bedienelements (9) umgeben ist.

4. Bedienvorrichtung nach einem der vorhergehenden Ansprüche, **dadurch gekennzeichnet, dass** das Bedienelement (9) eine obere (10) und eine untere Abdeckung (19) aufweist, die miteinander verbunden sind und ein geschlossenes Bedienelement (9) bilden, und eine Lichtquelle (31, 32) und ein Lichtleiter (36 bis 38) in der oberen Abdeckung (10) integriert sind.

5. Bedienvorrichtung nach einem der vorhergehenden Ansprüche, **dadurch gekennzeichnet, dass** mittels spezifischer Lichtabstrahlung durch die das Licht abstrahlende Einrichtung (29) des Bedienelements (9) im Hinblick auf Abstrahlrichtung und/oder Lichtfarbe und/oder Betriebsart der Lichtquelle (31, 32) spezifische Betriebseinstellungen des Kochfelds (1) optisch anzeigbar sind.

6. Bedienvorrichtung nach einem der vorhergehenden Ansprüche, **dadurch gekennzeichnet, dass** die Lichtquelle (31, 32) auf einem Schaltungsträger (26) angeordnet ist, welcher in einer Aussparung (11, 14), insbesondere an einer Oberseite einer Aussparung (11, 14) in einer oberen Abdeckung (10) des Bedienelements (9) angeordnet ist und die Lichtquelle (31, 32) sich in die obere Abdeckung (10) erstreckt.

7. Bedienvorrichtung nach einem der vorhergehenden Ansprüche, **dadurch gekennzeichnet, dass** das Bedienelement (9) eine integrierte Energieversorgungseinrichtung für die das Licht abstrahlende Einrichtung (29) aufweist.

8. Kochfeld (1) zum Zubereiten von Lebensmitteln mit einer Bedienvorrichtung (8) nach einem der vorhergehenden Ansprüche.

## Claims

1. Operating device for a cooking hob (1), having an operating surface (3) and having an operating element (9) that can be held by magnetic force on the operating surface (3) of the cooking hob (1), which is controllable using the operating device (8), and that can move relative to the operating surface (3), from where it can be removed and positioned, and the operating element (9) has a light-emitting device (29), wherein the light-emitting device (29) has at least one light source (31, 32) arranged inside the operating element (9) and the light emitted by the light source (31, 32) can be conducted by means of at least one light guide (36 to 38) to a light exit point (39, 40) of the operating element (9), **characterised in that** the light emitted by the light source (31, 32) can be emitted directed downwards from the operating element (9), and a visual element ensuring the targeted light emission in a projecting preferred direction (34, 42 to 44) is arranged at a light exit point (39, 40) of the operating element (9), and the targeted light emission comprises an obliquely downwardly directed preferred direction (34), when the operating element (9) is arranged on the operating surface (3), for which purpose a prism (41) ensuring the targeted light emission in a projecting preferred direction (34, 42 to 44) is arranged at a perimeter-side light exit point of the operating element (9).

2. Operating device according to claim 1, **characterised in that** the light source (31, 32) is a light-emitting diode.

3. Operating device according to claim 1 or 2, **characterised in that** the light source (31, 32) is integrated into the operating element (9) and is surrounded by the material of the operating element (9).

4. Operating device according to one of the preceding claims, **characterised in that** the operating element (9) has an upper (10) and a lower cover (19), which are interconnected and form a closed operating element (9), and a light source (31, 32) and a light guide (36 to 38) are integrated into the upper cover (10).

5. Operating device according to one of the preceding claims, **characterised in that** specific operating settings of the cooking hob (1) can be visually displayed by means of specific light emission by the light-emitting device (29) of the operating element (9) with regard to emission direction and/or light colour and/or operating mode of the light source (31, 32).

6. Operating device according to one of the preceding claims, **characterised in that** the light source (31, 32) is arranged on a circuit carrier (26) which is arranged in a recess (11, 14), in particular on an upper side of a recess (11, 14) in an upper cover (10) of the operating element (9) and the light source (31, 32) extends into the upper cover (10).

7. Operating device according to one of the preceding claims, **characterised in that** the operating element (9) has an integrated power supply device for the light-emitting device (29).

8. Cooking hob (1) for preparing food, with an operating device (8) according to one of the preceding claims.

## Revendications

1. Dispositif de commande pour une table de cuisson (1), comprenant une surface de commande (3) et comprenant un élément de commande (9) qui peut être maintenu au moyen de force magnétique sur la surface de commande (3) de la table de cuisson (1) commandable à l'aide du dispositif de commande (8) et est déplaçable par rapport à la surface de commande (3) et, de là, peut être positionné de manière amovible, et l'élément de commande (9) présentant un dispositif (29) rayonnant la lumière, le dispositif (29) rayonnant la lumière présentant au moins une source lumineuse (31, 32) disposée à l'intérieur de l'élément de commande (9), et la lumière émise par la source lumineuse (31, 32) pouvant être conduite à un point de sortie de lumière (39, 40) de l'élément de commande (9) au moyen d'au moins une fibre optique (36 à 38), **caractérisé en ce que** la lumière émise par la source lumineuse (31, 32) peut être rayonnée par l'élément de commande (9) en étant dirigée vers le bas, et **en ce qu'**un élément optique garantissant le rayonnement lumineux précis dans une direction préférentielle (34, 42 à 44) de projection est disposé à un point de sortie de lumière (39, 40) de l'élément de commande (9), et **en ce que** le rayonnement lumineux précis comprend une direction préférentielle dirigée de manière oblique vers le bas lorsque l'élément de commande (9) est disposé sur la surface de commande (3), pour lequel but un prisme (41) garantissant le rayonnement lumineux précis dans une direction préférentielle (34, 42 à 44) de projection est disposé à un point, côté circonférence, de sortie de lumière de l'élément de commande (9).

2. Dispositif de commande selon la revendication 1, **caractérisé en ce que** la source lumineuse (31, 32) est une diode électroluminescente.

3. Dispositif de commande selon la revendication 1 ou 2, **caractérisé en ce que** la source lumineuse (31, 32) est intégrée dans l'élément de commande (9) et est entourée par la matière de l'élément de commande (9).

4. Dispositif de commande selon l'une quelconque des revendications précédentes, **caractérisé en ce que** l'élément de commande (9) présente un recouvrement supérieur (10) et un recouvrement inférieur (19) qui sont reliés entre eux et forment un élément de commande (9) fermé, et **en ce qu'**une source lumineuse (31, 32) et une fibre optique (36 à 38) sont intégrées dans le recouvrement supérieur (10).

5. Dispositif de commande selon l'une quelconque des revendications précédentes, **caractérisé en ce que** des réglages opérationnels spécifiques de la table de cuisson (1) sont visualisables optiquement au moyen d'un rayonnement lumineux spécifique à travers le dispositif (29) rayonnant la lumière de l'élément de commande (9), au regard de la direction de rayonnement et/ou de la couleur de la lumière et/ou du mode opérationnel de la source lumineuse (31, 32).

6. Dispositif de commande selon l'une quelconque des revendications précédentes, **caractérisé en ce que** la source lumineuse (31, 32) est disposée sur un support de circuit (26) qui est disposé dans un évidement (11, 14), notamment sur un côté supérieur d'un évidement (11, 14) situé dans un recouvrement supérieur (10) de l'élément de commande (9), et **en ce que** la source lumineuse (31, 32) s'étend dans le recouvrement supérieur (10).

7. Dispositif de commande selon l'une quelconque des revendications précédentes, **caractérisé en ce que** l'élément de commande (9) présente un dispositif intégré d'alimentation en énergie pour le dispositif (29) rayonnant la lumière.

8. Table de cuisson (1) destinée à la préparation d'aliments à l'aide d'un dispositif de commande (8) selon l'une quelconque des revendications précédentes.
